# EUROPEAN PATENT SPECIFICATION

(11) **EP 3 425 743 B1**
(45) Date of publication and mention of the grant of the patent: **23.10.2019**
(21) Application number: 18182268.5
(22) Date of filing: 06.07.2018
(51) Int. Cl.: H02J 7/00, H01R 13/512, G01R 31/396, G01R 31/364, H01R 103/00, H01R 13/24, H01R 11/18

(54) **ELECTRICAL CONNECTOR FOR CHARGING ELECTRIC STORAGE BATTERY CELLS**
ELEKTRISCHER VERBINDER ZUM LADEN VON ELEKTRISCHEN SPEICHERBATTERIEZELLEN
CONNECTEUR ÉLECTRIQUE DESTINÉ À CHARGER DES CELLULES DE BATTERIE DE STOCKAGE ÉLECTRIQUE

(30) Priority: 07.07.2017 IT 201700076921
(43) Date of publication of application: 09.01.2019
(73) Proprietor: SOVEMA GROUP S.p.A., 37069 Villafranca di Verona (VR) (IT)
(72) Inventor: FERRARESE, Luciano, 37030 Lavagno (VR) (IT)
(74) Representative: Gallo, Luca

(56) References cited:
- KR-A- 20030 007 279
- US-A- 6 140 905

## Description

### Field of application

The present invention regards an electrical connector for charging electric storage battery cells according to the preamble of the main independent claim.

The present electrical connector is inserted in the industrial field of the production of electric storage batteries, which are well-known to be employed in many different applications, such as in the automotive field, or in uninterrupted power supply, in forklifts or in many other applications where it is necessary to have a storage of electrical energy.

The present electrical connector is employed in the plants and processes for charging electric storage batteries of any type and in particular lithium storage batteries.

More in detail, the present electrical connector is intended to be employed in the final step of the production process of storage batteries, i.e. in the step of the charging thereof (formation) when, with suitable electrical power plants, a plurality of storage batteries are simultaneously subjected to controlled charging processes.

More particularly, the electrical connector in question is intended to be advantageously employed in automated charging plants where the plurality of connectors is automatically electrically brought into contact with a corresponding plurality of cells of the storage batteries for the execution of the aforesaid controlled charging processes.

### State of the art

In the industrial field of production of electric storage batteries, it is known to charge a plurality of storage batteries simultaneously, controlling the charging steps with sensors and/or measurements that detect, for example, the response of the single cell of the storage battery to the electrical power supply.

As is known, lead storage batteries are power supplied in the step of formation with the cells in series and are only controlled overall at the final poles of the storage battery, while lithium storage batteries - the latter available with various chemical types (e.g. lithium iron phosphate, lithium iron disulfide, lithium manganese dioxide, lithium thionyl chloride, lithium polymers and still others) - are power supplied during the cell-by-cell formation, and thus the latter require being separately controlled both for safety reasons and to prevent for example phenomena of self-discharging in the single cells.

More in detail, the storage batteries are generally arranged in groups on a common base, on which an electrical manifold descends bearing, mounted thereon, a plurality of electrical connectors aimed to come into contact with the electrodes of the cells of the storage batteries in order to power them with the provided charge current.

In particular, for lithium storage batteries it is, as is known, during the formation step necessary to control the potential difference that is created between the electrodes of each cell, or better yet it is necessary to control the potential difference within the single cells for the entire load cycle and/or upon varying the charge current.

In the field of production of electric storage batteries, there is the particular need to overcome some drawbacks linked to the possibility that an oxide layer is generated on the surface of the electrodes of the cell or linked to an imperfect alignment of the electrode and of the connector which must come into contact in order to transmit the electrical power to the cell.

Electrical connectors are known which can be mounted on movable manifolds, having a relatively wide contact surface, such to overcome the abovementioned problems of electrode / connector alignment.

In addition, on the contact surface of the aforesaid connectors, a knurled surface is made with reliefs that have the object of breaking and penetrating the oxide layer so to be able to power the cell with the provided charge current.

The abovementioned electrical connectors are employed for achieving a control of the potential difference within the cell, through potential measurements carried out on the same electrical connectors in a distal position with respect to the contact surface between the connector and the electrode, through which the electrical power supply takes place. In order to control the formation process, as mentioned above it is necessary to know the potential difference present at the ends of the electrodes of each cell, since this is indicative of the charging that occurred within the same.

The electrical connector of known type briefly described above has in practice proven that it does not lack drawbacks. An important drawback lies in the fact that the measurement of the potential difference is not carried out directly at the ends of the electrodes of each cell but on the connectors in order to power them with the charge current or more generally on the electrical power circuit. One such measurement, executed at points of the circuit that are not ends of the electrodes of the cell, is affected by an imprecision due to the fact that the voltage drop of the electrical power circuit connection - in particular due to the contact resistance with the electrode - is added to the potential difference that actually exists between the electrodes of the cell.

The contribution of this voltage drop on the measurement to be carried out is difficult to calculate with precision, in particular since it depends on the conditions on the electrical connection which in turn generally depend on the cleaning and on the degree of oxidation of the contacts between the electrode and the connector.

On the other hand, the power supply of the storage battery that brings the ends of a cell to an incorrect potential difference can lead, in particular with lithium cells, to self-discharges in the cell itself or to dangerous situations, actually bordering on the explosion of the cell itself.

In summary, the above-described connector is usually employed in apparatuses for forming lithium storage batteries comprising a movable manifold which bears, mounted thereon, a plurality of the aforesaid electrical connectors in order to bring them in contact with a plurality of electrodes of one or more side-by-side storage batteries, given that the contact surface of each single connector is wider than that of the electrode such to remedy possible misalignments. In addition, such contact surface of the connector is knurled in order to penetrate the possible surface oxide of the electrode.

More in detail, such apparatuses for forming storage batteries comprise a controlled electrical power supply adapted to supply the provided charge current and means for measuring the potential difference detected on the connectors for connecting to the electrodes of each cell.

Also known are electrical connectors, in particular employed in apparatuses for forming lithium storage batteries, which comprise a bush made of conductive material, and an electrical contacting element constituted by a pogo pin, it too made of conductive material mounted coaxially with the center of the bush.

More in detail, the bush is susceptible of being power supplied by an electrical power source, is provided with an internal cavity delimited by a substantially flat end wall, which is susceptible of abutting against, by means of a contact surface thereof, an electrode of a cell of an electric storage battery, in order to electrically charge it.

The pogo pin, in turn, is susceptible of being connected to measurement means and of abutting against, by means of a free end thereof, the electrode of the cell of the electric storage battery, in order to carry out electrical measurements, in particular for measuring the potential difference at the ends of the electrodes of the cell.

More in detail, the pogo pin, employed in the apparatuses for charging the electric storage batteries, usually has cylindrical form, and is pushed by a spring projecting from the contact surface of the electrical connector such that it can elastically abut against the surface of the electrode of a cell. The pogo pin is composed of a first portion intended to electrically contact the electrode of a cell, and a second portion connected to the measurement means. The two portions are maintained in mechanical and electrical connection with each other by the abovementioned spring which thus is interposed between the two portions.

Electrical connectors are known, characterized in that they have a contact surface on which one or more pogo pins are present; each of these pogo pins is slidable against the action of the aforesaid spring.

Nevertheless, also this known electrical connector embodiment has several drawbacks. A first drawback is linked to the poor mechanical strength of the pogo pin. Indeed, in practice it is frequently deformed following impact and/or pressures imperfectly oriented along the longitudinal axis of the pogo pin itself.

A second drawback is linked to the misalignment that can occur between the contact surface of the connector and the electrode of the cell due to possible deformations. Such misalignment can lead to the lack of contact between the pogo pin and the electrode with consequent error of measurement of the potential difference.

A third drawback is connected to the imprecision of the electrical measurement of the potential difference due to the use of the pogo pin. The measurement means in fact provide for detecting the passage of small current through the spring of the pogo pin. Said spring is constituted by a wire which has high resistance, above all due to its reduced section. It follows that, also in this case, a contribution of potential drop is present that is hard to estimate and which comes to be added to the potential difference actually present between the electrodes of the electrical cell, which must be measured with precision.

Therefore, the measurement that results is not very accurate and in the end the cell charging process results hard to control and thus potentially dangerous, given that the cell could be subjected to a potential difference different from that required for a correct charging process.

In addition, oxide layers could be created on the pogo pins that cannot be mechanically removed with ease, e.g. by means of brushing, due to the mechanical weakness of the pogo pin that is currently used.

The document KR 20030007279 describes a probe of known type for executing tests on lithium batteries, which comprises a support head provided with an end wall on which a front opening is made with cross form. In such front opening, a contacting element is slidably inserted that is susceptible of contacting the terminal of the battery in order to carry out electrical measurements. More in detail, the contacting element comprises a support base with cross form bearing, mounted thereon, a plurality of contact tips adapted to project beyond the end wall of the support head in order to contact the terminal of the battery. The probe described in the document KR 20030007279 has a reduced contact surface of the support head on the battery due to the front opening of the end wall thereof, as well as a limited contact zone of the tips of the contacting element since the position of such tips is located within the aforesaid front opening.

### Presentation of the invention

In this situation, the problem underlying the present invention is therefore that of overcoming the drawbacks of the above-mentioned prior art, by providing an electrical connector for charging electric storage battery cells which allows carrying out precise electrical measurements in the cell subjected to load cycle.

Another object of the present invention is to provide an electrical connector for charging electric storage battery cells, which is mechanically strong.

Another object of the present invention is to provide an electrical connector for charging electric storage battery cells, which is capable of compensating for imprecise positioning of the storage battery or variations of the centering of the electrodes following expansions of the cell.

Another object of the present invention is to provide an electrical connector for charging electric storage battery cells, which is simple to produce and easy to maintain.

Another object of the present invention is to provide an electrical connector for charging electric storage battery cells, which is safe and entirely reliable in operation.

Such problems are resolved through an electrical connector for an apparatus for charging electric storage battery cells according to claim 1, which comprises a bush made of conductive material, susceptible of being power supplied by an electrical power source, and provided with an internal cavity. Such internal cavity is delimited by a substantially flat end wall, a bottom wall and a first lateral wall of the bush. The end wall is susceptible of abutting against, by means of a contact surface thereof, an electrode of an electric storage battery, in order to electrically charge it. The electrical connector also comprises at least one electrical contacting element made of conductive material, such as copper. This contacting element is mounted inside the bush and can be connected to a measuring device. Such contacting element can abut against, by means of a free end thereof, the electrode of the electric storage battery, in order to carry out electrical measurements on the storage battery.

According to the invention, the electrical contacting element comprises a common base electrically connected to a electrical measurement cable, susceptible of being connected to the measuring device. The contacting element also comprises a plurality of pins, which are extended starting parallel to each other from said common base, and traverse a corresponding plurality of through holes obtained on said end wall. The pins can project, outside the bush, with a free end thereof. Electrical isolation means are also present, which are housed within the cavity of the bush in order to electrically isolate the bush from the electrical contacting element. Due to this connector, it is possible to control the process of charging electrical cells of electric storage batteries, increasing the reliability of the process.

In addition, this connector is stronger and its maintenance is simple and inexpensive with respect to the connector with a single pogo pin.

### Brief description of the drawings

The technical characteristics of the invention, according to the aforesaid objects, can be clearly seen from the contents of the below-reported claims and the advantages thereof will be more evident in the following detailed description, made with reference to the enclosed drawings which represent a merely exemplifying and non-limiting embodiment of the invention, in which:

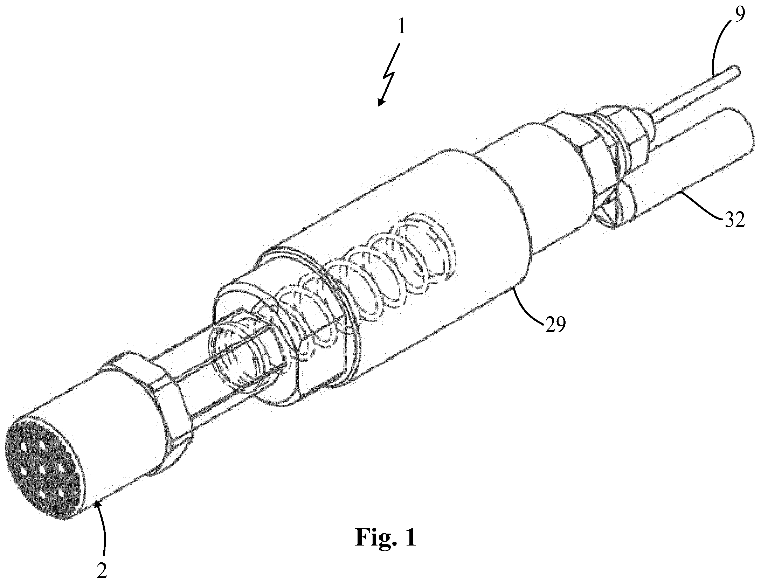

- figure 1 shows an axonometric view of an electrical connector for charging electric storage battery cells according to the present invention;

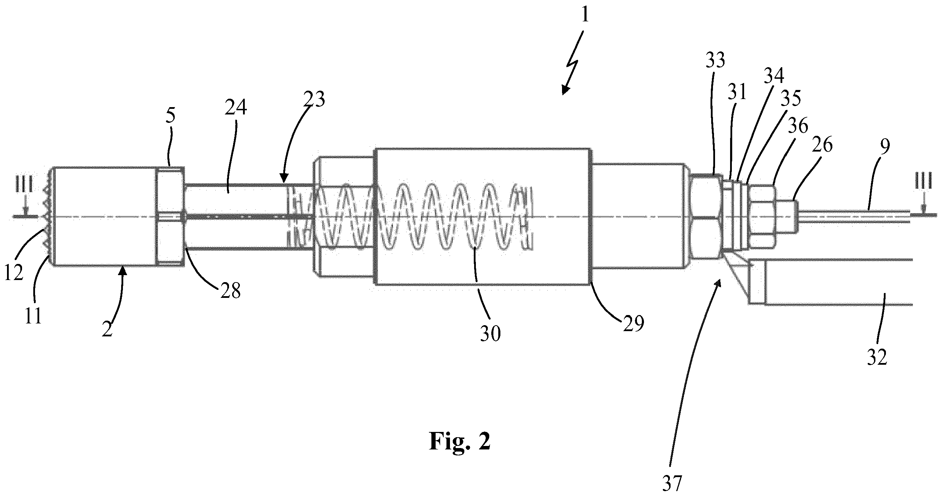

- figure 2 shows a side view of the electrical connector of figure 1, according to the present invention;

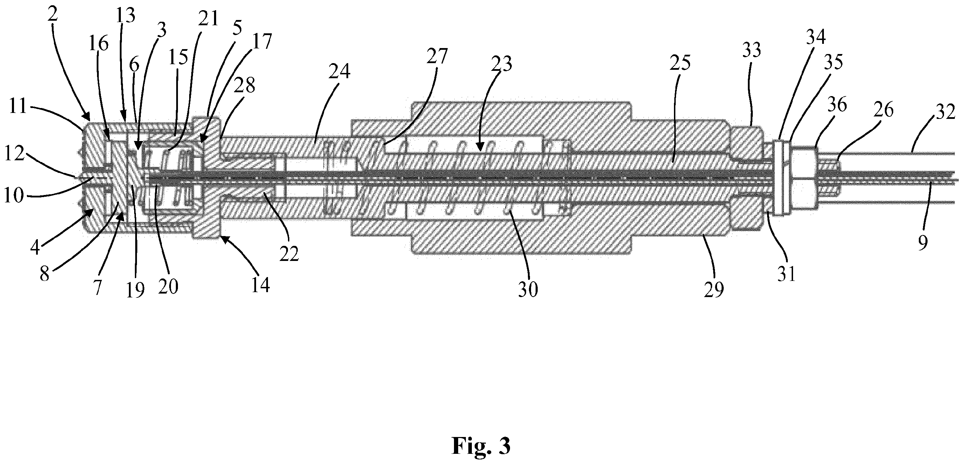

- figure 3 shows a longitudinal section view, made along the trace III-III of figure 2, of the electrical connector according to the invention;

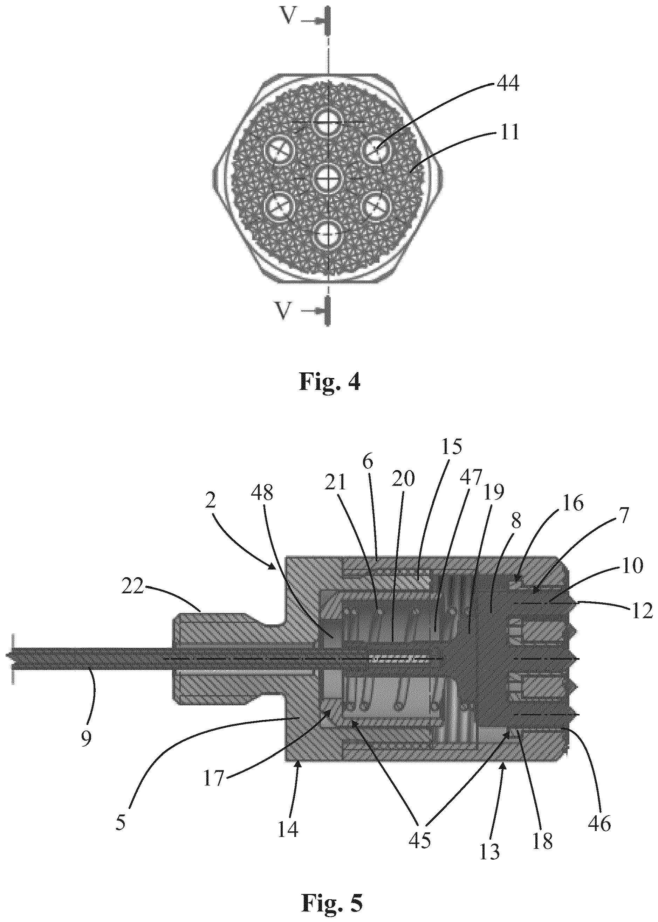

- figure 4 shows an axonometric front view of a detail of the electrical connector according to the present invention, relative to a bush;
- figure 5 shows a longitudinal section view, made along the trace V-V of figure 4, of the bush of the electrical connector according to the invention;
- figure 6 shows a support structure of an apparatus for charging electric storage battery cells, on which a plurality of electrical connectors according to the present invention are mounted.

### Detailed description of a preferred embodiment

With reference to the enclosed drawings, reference number 1 overall indicates an electrical connector for charging electric storage battery cells, object of the present invention.

Such electrical connector 1 is intended to be advantageously employed in an apparatus for charging cells for the many different types of storage batteries, such as lead storage batteries, nickel storage batteries (nickel-cadmium, nickel-hydride metal...) and lithium storage batteries.

In accordance with the embodiment illustrated in the enclosed figures, the connector is particularly intended for charging cells of storage batteries of lithium type, the latter available with different chemical types such as lithium iron phosphate, lithium iron disulfide, lithium manganese dioxide, lithium thionyl chloride, lithium polymers and still other types.

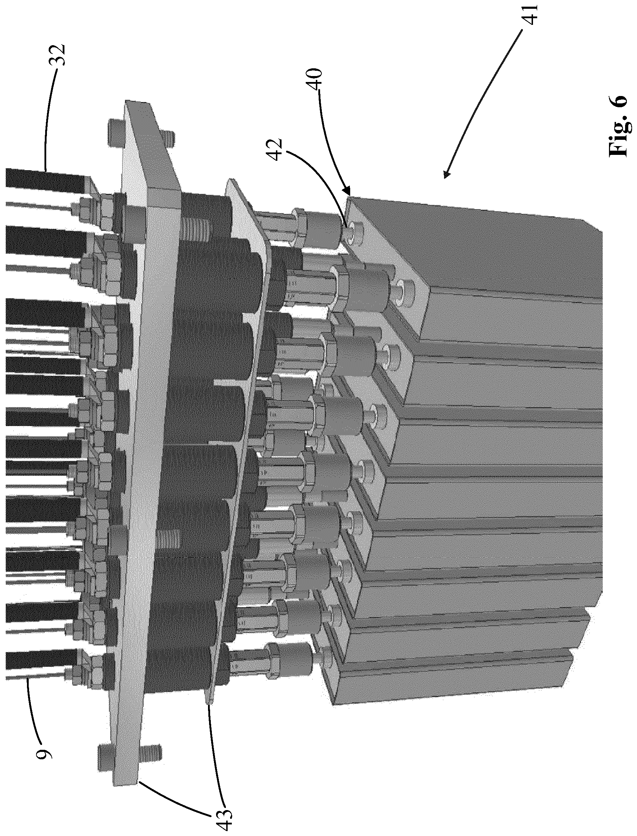

This electrical connector 1 can be advantageously mounted in a position contiguous to a plurality of equivalent connectors on a common support structure indicated in figure 6 with reference number 43. Such support structure 43 is movable with respect to the storage battery or to a plurality of side-by-side storage batteries, in order to be able to advantageously charge the storage batteries and carry out electrical measurements on the cells of the same storage batteries.

The electrical connector 1, object of the present invention, comprises a bush 2 made of conductive material, such as copper, which is susceptible of being power supplied by an electrical power source of the apparatus for charging the cells.

The bush 2 preferably has a cylindrical shape and at its interior delimits a cavity 3, also advantageously with cylindrical form. Such internal cavity 3 is, more particularly, delimited by several walls of the bush 2 and more precisely by: a substantially flat end wall 4, a bottom wall 5 and a lateral wall 6 which will be better specified hereinbelow. The end wall 4 of the bush 3 has a contact surface 11, which is intended to abut against an electrode 42 of a cell 40 of an electric storage battery 41, in order to charge the cell 40 itself. Such contact surface 11 of the bush 3 can be advantageously knurled in order to improve the electrical contact with the electrode 42, by traversing the oxide layers that may have formed on the electrode 42 itself.

In particular, the bush 2 is advantageously formed by two elements: a first shaped element 13 and a second shaped element 14 that are mechanically coupled together. The first shaped element 13 has substantially U shape and comprises a wall which acts as end wall of the bush and which hereinbelow will be termed end wall 4, and a first lateral wall 6, which is connected by means of a first bend to the end wall 4.

The second shaped element 14 is provided with a U-shaped portion, which comprises a bottom wall 5 and a second lateral wall 15. Also this second lateral wall 15, like the preceding, is connected by means of a second bend to the other wall, or in this case to the bottom wall 5.

The mechanical coupling between the two shaped elements 13, 14 is attained due to a screwing engagement between the first lateral wall 6 of the first shaped element 13 and the second lateral wall 15 of the second shaped element 14.

In accordance with the preferred embodiment illustrated in the enclosed figures, such second shaped element 14 comprises a neck portion 22, which is advantageously threaded. Such neck portion 22 departs from the bottom wall 5, being extended in a direction opposite the second lateral wall 15 of the second shaped element 14.

These shaped elements 13 and 14 delimit the cavity 3 of the bush 2 between them, in accordance with the above-described embodiment.

Within the cavity 3 of the bush 2, an electrical contacting element 7 is positioned, it too constructed with a conductive material, such as copper. The electrical contacting element 7 has a free end 12, which comes into contact with the electrode of the cell of the storage battery, and more precisely with its upper terminal face. Such electrical contacting element 7 is intended to be connected to measurement means of the apparatus for charging the cells, in order to carry out electrical measurements inside the cell, in particular relative to the charge state reached by the cell, or voltage state reached at the ends of its electrodes 42.

According to the idea underlying the present invention, the electrical contacting element 7 comprises a common base 8, which is electrically connected to a cable 9 in turn intended to be connected to the measurement means. Starting from the common base 8, a plurality of pins 10 are extended parallel to each other, and such pins 10 traverse a corresponding plurality of through holes 44. The latter are made on the end wall 4 of the bush 2. More in detail, the pins 10 project from the contact surface 11 of the end wall 4 with their free end 12. In addition, still according to the idea underlying the present invention, also electrical isolation means 45 are present within the cavity 3 of the bush 2, and such means 45 electrically isolate the electrical contacting element 7 from the bush 2.

Due to the aforesaid characteristics, the electrical connector 1, object of the present invention, allows recharging electric storage battery cells and, simultaneously, controlling electrical parameters such as the potential difference at the ends of the electrodes of each single cell, as well as allowing a simple and inexpensive maintenance.

Preferably, the contacting element 7 is provided with a tube 20 which is extended from the common base 8 thereof in opposite direction with respect to the pins 10. This tube 20 is internally hollow in order to be able to advantageously receive the measurement cable 9, which is placed in electrical contact with the tube 20, for example by means of a crimping process.

In accordance with the embodiment illustrated in the enclosed figures, the isolation means 45 comprise a first isolation body 16 and a second isolation body 17. The first isolation body 16 is provided with a base element 18, interposed between the common base 8 of the contacting element 7 and the internal face of the end wall 4 of the bush 2, and with a plurality of tubular elements 46.

These tubular elements 46 are connected at one end thereof to the base element 18 and are housed in the through holes 44 of the end wall 4, in order to isolate the pins 10 of the contacting element 7 from the bush 2, i.e. in order to avoid such pins 10 from coming into contact with the end wall 4 of the bush 2.

The second isolation body 17 is in turn advantageously provided with a first opening 47, directed towards the end wall 4 and traversed by the tube 20 of the electrical contacting element 7, and a second opening 48 directed towards a bottom wall 5 of the cavity 3. This second opening 48 faces the end wall 4 and is traversed by the electrical measurement cable 9. The second isolation body 17 comprises an annular portion placed to cover the bottom wall 5 of the cavity 3, and preferably also a lateral portion, which covers the second lateral wall 15 of the second shaped element 14.

In addition to that stated above, the electrical connector 1 comprises first elastic means 21, which are advantageously housed within the cavity 3 of the bush 2 and act on the electrical contacting element 7 in order to push the free ends 12 of the pins 10 towards the contact surface 11.

In the embodiment represented in the enclosed figures, the aforesaid first elastic means 21 are preferably constituted by a first helical spring 21, which is mounted coaxially with the electrical measurement cable 9.

More in detail, the first helical spring 21 abuts, at a first end, against the annular portion of the second isolation body 17, and at a second end against the common base 8 of the electrical contacting element 7.

In particular, the second end of the first helical spring 21 is engaged in a retention relationship on a projection 19 that departs from the common base 8 of the electrical contacting element 7, in a direction opposite that of the pins 10 and which is then advantageously extended in such direction by the abovementioned tube 20 for the fixing of the measurement cable 9.

Additionally, the electrical connector 1 comprises an elongated spacer body 23 composed of a first externally threaded terminal portion 26, a second central portion 25 and a third terminal portion with greater section 24. In particular, the second central portion 25 is extended starting from a shoulder 27 (narrowing) which delimits it from the third terminal portion with greater section 24, up to the start of the first threaded terminal portion 26.

In turn, the third terminal portion with greater section 24 is extended from the shoulder 27 up to an end section 28 of the spacer 23 directed towards the bush 2. Such elongated spacer 23 is advantageously provided with a through cavity in order to allow the internal passage of the measurement cable 9. In addition, the through cavity of the elongated spacer 23 has, at the third terminal portion with greater section 24, an enlargement that defines a central hole, which is advantageously threaded, at least at a first section directed towards the bush 2, in order to be able to receive the neck portion 22 in a screwing relationship and hence mechanical retention relationship; such neck portion 22, suitably threaded, is part of the second shaped element 14 of the bush 2. More generally, the neck portion 22 is fixed to the elongated spacer 23 with fixing means that can be different from a screw/nut screw coupling indicated above where, without departing from the protective scope of the present patent, the term fixed must indicate any one form of mechanical coupling between the elongated spacer 23 and the bush 2. The same term must also include the embodiment that provides for making elongated spacer 23 integral with the second shaped element 14 of the bush 2.

Advantageously, the electrical connector 1 also comprises a hollow sleeve 29 which is externally mounted with respect to the spacer 23, in a manner such that the spacer 23 can advantageously slide within the sleeve 29, against the action of second elastic means 30.

These second elastic means 30 are interposed between the spacer 23 and the sleeve 29 and more particularly between the shoulder 27 of the spacer 23 and a second shoulder of the sleeve 29. The second elastic means are, in this embodiment, advantageously constituted by a second helical spring 30.

The electrical connector 1 advantageously also comprises a connection clamp 37 for an electrical power cable 32. More in detail, on the first externally threaded terminal portion 26, a square washer 31 is housed that is made of conductive material, such as copper or steel. The square washer 31 is connected to the electrical power cable 32, which carries the charge current for the cell of the storage battery, and is advantageously fastened in position by a nut-lock nut system. In particular, a nut 33 is abutted against a first side of the square washer 31, such nut 33 advantageously constituted by a conductive material, while the second side of the square washer 31, opposite the first, abuts against a flat washer 34. Such flat washer 34 is side-by-side an elastic washer 35, which is in contact with the flat washer 34 on a first side while on a second side, opposite the first, it is in contact with a lock nut 36.

The invention thus conceived therefore attains the pre-established objects.

In particular, the claimed configuration, in which the pins 10 of the electrical contacting element 7 are inserted in corresponding through holes 44 of the end wall 4 of the bush 2, allows uniformly distributing the pins 10 over the area of the end wall 4 for an optimal detection of the measurements, simultaneously obtaining a high contact surface area 11 of the latter for charging the electric storage battery 41.

## Claims

1. Electrical connector (1) for an apparatus for charging electric storage battery cells, which comprises:
- a bush (2) made of conductive material, which is susceptible of being power supplied by an electrical power source, is provided with an internal cavity (3) delimited by a substantially flat end wall (4), a bottom wall (5) and a first lateral wall (6) of the bush (2), said end wall (4) being susceptible of abutting against, by means of a contact surface (11) thereof, an electrode (42) of a cell (40) of an electric storage battery (41), in order to electrically charge it;
- at least one electrical contacting element (7) made of conductive material, mounted inside said bush (2), susceptible of being connected to measurement means and of abutting against, by means of a free end (12) thereof, the electrode (42) of said cell (40), in order to carry out electrical measurements;
wherein said electrical contacting element (7) comprises:
- a common base (8) electrically connected to a cable (9) of said measurement means;
- a plurality of pins (10), which are extended, parallel to each other, starting from said common base (8);
- electrical isolation means (45), which are housed within the cavity (3) of said bush (2) in order to electrically isolate said bush (2) from said electrical contacting element (7);
said electrical connector (1) being **characterized in that** the pins (10) of said electrical contacting element (7) traverse a corresponding plurality of through holes (44) made on said end wall (4) and are susceptible of projecting from said contact surface (11), with the free end (12) thereof;
wherein said electrical connector (1) comprises first elastic means (21), which are housed within the internal cavity (3) of said bush (2) and act against said electrical contacting element (7) for pushing the free ends (12) of said pins (10) outside the contact surface (11) of said end wall (4);
wherein said electrical isolation means (45) comprise a first isolation body (16) provided with:
- a base element (18) interposed between the common base (8) of said contacting element (7) and the internal face of the end wall (4) of said bush (2); and
- a plurality of tubular elements (46) which are connected to said base element (18) and are inserted in the through holes (44) of said end wall (4) in order to isolate said pins (10) from said bush (2).

2. Electrical connector (1) according to claim 1, **characterized in that** said bush (2) comprises a first shaped element (13) with substantially U shape comprising said end wall (4) and said first lateral wall (6) connected by means of a first bend to said end wall (4), and a second shaped element (14) provided with a U-shaped portion, which comprises said bottom wall (5) and a second lateral wall (15) connected by means of a second bend to said bottom wall (5); the first lateral wall (6) of said first shaped element (13) being mechanically connected in a screwing relationship to the second lateral wall (15) of said second shaped element (14); said shaped elements (13,14) delimiting the internal cavity (3) of said bush (2) between them.

3. Electrical connector (1) according to claim 2, **characterized in that** said electrical isolation means (45) comprise a second isolation body (17), which is provided with a first opening (47) directed towards said end wall (4) and traversed by said electrical contacting element (7) and with a second opening (48) directed towards the bottom wall (5) of said second shaped element (14), facing said end wall (4) and traversed by the cable (9) of said measurement means; said second isolation body (17) at least partially covering the internal surface of the internal cavity (3) of said bush (2) and comprising an annular portion placed to cover the bottom wall (5) of said second shaped element (14) and a lateral portion to cover the second lateral wall (15) of said second shaped element (14).

4. Electrical connector (1) according to claim 3, **characterized in that** said first elastic means are constituted by a helical spring (21) mounted coaxially with said cable (9) and abutting, at a first end, against the annular portion of said second isolation body (17) and, at a second end, against the common base (8) of said electrical contacting element (7).

5. Electrical connector (1) according to claim 4, **characterized in that** the second end of the helical spring (21) is engaged in a retention relationship with a projection (19) that departs from said common base (8) in a direction opposite said pins (10).

6. Electrical connector (1) according to claim 2, **characterized in that** said second shaped element (14) comprises a neck portion (22) which departs from said bottom wall (5), being extended in a direction opposite the second lateral wall (15) of said second shaped element (14), said neck portion (22) being fixed to an elongated spacer body (23); said electrical connector (1) also comprising a hollow sleeve (29) mounted outside said spacer (23); said spacer (23) being susceptible of sliding within said sleeve (29) against the action of second elastic means (30).

7. Electrical connector (1) according to claim 6, **characterized in that** said second elastic means (30) are interposed between a first shoulder (27) of said spacer (23) and a second shoulder of said hollow sleeve (29).

## Patentansprüche

1. Elektrischer Verbinder (1) für eine Vorrichtung zum Laden von elektrischen Speicherbatteriezellen, der Folgendes umfasst:
- eine aus leitfähigem Werkstoff hergestellte Buchse (2), die geeignet ist, von einer Stromquelle mit Strom versorgt zu werden, die mit einem von einer im Wesentlichen flachen Endwand (4), einer Bodenwand (5) und einer ersten Seitenwand (6) der Buchse (2) begrenztem inneren Hohlraum (3) ausgestattet ist, wobei die genannte Endwand (4) geeignet ist, mittels einer Kontaktfläche (11) derselben an einer Elektrode (42) einer Zelle (40) einer elektrischen Speicherbatterie (41) anzuliegen, um diese elektrisch zu laden;
- mindestens ein in der genannten Buchse (2) montiertes, aus leitfähigem Werkstoff hergestelltes elektrisches Kontaktelement (7), das geeignet ist, an Messvorrichtungen angeschlossen zu werden und mit einem freien Ende (12) derselben an der Elektrode (42) der genannten Zelle (40) anzuliegen, um elektrische Messungen auszuführen;
- wobei das genannte elektrische Kontaktelement (7) Folgendes umfasst:
- eine elektrisch an ein Kabel (9) der genannten Messvorrichtungen angeschlossene gemeinsame Basis (8);
- eine Vielzahl von Kontakten (10), die von der genannten gemeinsamen Basis (8) ausgehend parallel zueinander verlaufen;
- elektrische Isoliervorrichtungen (45), die in dem Hohlraum (3) der genannten Buchse (2) untergebracht sind, um die genannte Buchse (2) elektrisch von dem genannten elektrischen Kontaktelement (7) zu isolieren;
wobei der genannte elektrische Verbinder (1) **dadurch gekennzeichnet ist, dass** die Kontakte (10) des genannten elektrischen Kontaktelements (7) eine entsprechende Vielzahl von Durchgangslöchern (44) überqueren, die auf der genannten Endwand (4) angebracht und geeignet sind, von der genannten Kontaktfläche (11) mit ihrem freien Ende (12) vorzustehen;
wobei der genannte elektrische Verbinder (1) erste elastische Elemente (21) umfasst, die in dem inneren Hohlraum (3) der genannten Buchse (2) untergebracht sind und auf das genannte elektrische Kontaktelement (7) einwirken, um die freien Enden (12) der genannten Kontakte (10) aus der Kontaktfläche (11) der genannten Endwand (4) herauszuschieben;
wobei die genannten elektrischen Isoliervorrichtungen (45) einen ersten Isolierkörper (16) umfassen, der mit Folgendem ausgestattet ist:
- einem zwischen der gemeinsamen Basis (8) des genannten Kontaktelements (7) und der Innenfläche der Endwand (4) der genannten Buchse (2) eingesetztes Basiselement (18); und
- einer Vielzahl von an das genannte Basiselement (18) angeschlossenen und in die Durchgangslöcher (44) der genannten Endwand (4) eingesetzten Rohrelementen (46), um die genannten Kontakte (10) von der genannten Buchse (2) zu isolieren.

2. Elektrischer Verbinder (1) nach Anspruch 1, **dadurch gekennzeichnet, dass** die genannte Buchse (2) ein im Wesentlichen u-förmiges, die genannte Endwand (4) und die genannte erste Seitenwand (6) umfassendes erstes Formelement (13) umfasst, das mit Hilfe einer ersten Krümmung mit der genannten Endwand (4) verbunden ist, und ein mit einem u-förmigen Abschnitt ausgestattetes zweites Formelement (14), das die genannte Bodenwand (5) und eine zweite Seitenwand (15) umfasst, das mit Hilfe einer zweiten Krümmung mit der genannten Bodenwand (5) verbunden ist; wobei die erste Seitenwand (6) des genannten ersten Formelements (13) mechanisch in einem Schraubverhältnis mit der zweiten Seitenwand (15) des genannten zweiten Formelements (14) verbunden ist; wobei die genannten Formelemente (13, 14) den inneren Hohlraum (3) der genannten Buchse (2) zwischen sich begrenzen.

3. Elektrischer Verbinder (1) nach Anspruch 2, **dadurch gekennzeichnet, dass** die genannten elektrischen Isoliervorrichtungen einen zweiten Isolierkörper (17) umfassen, der mit einer zur der genannten Endwand (4) gerichteten und von dem genannten elektrischen Kontaktelement (7) überquerten ersten Öffnung (47) und mit einer zu der Bodenwand (5) des genannten zweiten Formelements (14) gerichteten zweiten Öffnung (48) vor der genannten Endwand (4) ausgestattet ist, die von dem Kabel (9) der genannten Messvorrichtungen überquert wird; wobei der zweite Isolierkörper (17) zumindest partiell die Innenfläche des inneren Hohlraums (3) der genannten Buchse (2) abdeckt und einen ringförmigen Abschnitt zum Abdecken der Bodenwand (5) des genannten zweiten Formelements (14) und einen seitlichen Abschnitt zum Abdecken der zweiten Seitenwand (15) des genannten zweiten Formelements (14) umfasst.

4. Elektrischer Verbinder (1) nach Anspruch 3, **dadurch gekennzeichnet, dass** die genannten ersten elastischen Elemente aus einer koaxial mit dem genannten Kabel (9) montieren Schraubenfeder (21) bestehen, die an einem ersten Ende an dem ringförmigen Abschnitt des genannten zweiten Isolierkörpers (17) und an einem zweiten Ende an der gemeinsamen Basis (8) des genannten elektrischen Kontaktelements (7) anliegt.

5. Elektrischer Verbinder (1) nach Anspruch 4, **dadurch gekennzeichnet, dass** das zweite Ende der Schraubenfeder (21) sich in einem Rückhalteverhältnis mit einem Vorsprung (19) befindet, der von der genannten gemeinsamen Basis (8) in einer der den genannten Kontakten (10) entgegengesetzten Richtung ausgeht.

6. Elektrischer Verbinder (1) nach Anspruch 2, **dadurch gekennzeichnet, dass** das genannte zweite Formelement (14) einen von der genannten Bodenwand (5) ausgehenden Halsabschnitt (22) umfasst, der in einer zu der zweiten Seitenwand (15) des genannten zweiten Formelements entgegengesetzten Richtung verläuft, wobei der genannte Halsabschnitt (22) an einem länglichen Abstandhalterkörper (23) angebracht ist; wobei der genannte elektrische Verbinder (1) außerdem eine außerhalb des genannten Abstandhalters (23) montierte hohle Muffe (29) umfasst; wobei der genannte Abstandhalter (23) geeignet ist, im Inneren der genannten Muffe (29) durch Wirkung zweiter elastischer Vorrichtungen (30) zu gleiten.

7. Elektrischer Verbinder (1) nach Anspruch 6, **dadurch gekennzeichnet, dass** die genannten zweiten elastischen Vorrichtungen (30) zwischen einem ersten Seitenteil (27) des genannten Abstandhalters (23) und einem zweiten Seitenteil der genannten hohlen Muffe (29) eingesetzt sind.

## Revendications

1. Connecteur électrique (1) pour un appareil destiné à charger des cellules de batterie de stockage électrique, comprenant :
- une bague (2) composée d'un matériau conducteur, susceptible d'être alimentée par une source d'énergie électrique, munie d'une cavité interne (3) délimitée par une paroi terminale (4) essentiellement plane, une paroi de fond (5) et une première paroi latérale (6) de la bague (2), ladite paroi terminale (4) pouvant, par une surface de contact (11), s'appuyer contre une électrode (42) d'une cellule (40) d'une batterie de stockage électrique (41), afin de la charger ;
- au moins un élément de contact électrique (7) composé d'un matériau conducteur, disposé à l'intérieur de ladite bague (2), pouvant être connecté à un moyen de mesure et, au moyen d'une extrémité libre (12) de celui-ci, pouvant s'appuyer contre l'électrode (42) de ladite cellule (40), afin d'effectuer des mesures électriques ;
dans lequel ledit élément de contact électrique (7) comprend :
- une base commune (8) connectée de manière électrique à un câble (9) dudit moyen de mesure ;
- une pluralité de broches (10), qui s'étendent parallèlement les unes par rapport aux autres depuis ladite base commune (8) ;
- des moyens d'isolation électrique (45), qui sont logés dans la cavité (3) de ladite bague (2) afin d'isoler électriquement ladite bague (2) dudit élément de contact électrique (7) ; ledit connecteur électrique (1) étant **caractérisé en ce que** les broches (10) dudit élément de contact électrique (7) traversent une pluralité de trous traversant (44) correspondants prévus dans ladite paroi terminale (4) et peuvent s'étendre par leur extrémité libre (12) en saillie depuis ladite surface de contact (11) ;
dans lequel ledit connecteur électrique (1) comprend des premiers moyens élastiques (21) qui sont logés dans la cavité interne (3) de ladite bague (2) et agissent contre ledit élément de contact électrique (7) pour pousser les extrémités libres (12) desdites broches (10) vers l'extérieur de la surface de contact (11) de ladite paroi terminale (4) ; dans lequel lesdits moyens d'isolation électrique (45) comprennent un premier corps isolant (16) muni de :
- un élément de base (18) interposé entre la base commune (8) dudit élément de contact (7) et la face interne de la paroi terminale (4) de ladite bague (2), et
- une pluralité d'éléments tubulaires (46) qui sont connectés audit élément de base (18) et qui sont insérés dans les trous traversants (44) de ladite paroi terminale (4) pour isoler lesdites broches (10) de ladite bague (2).

2. Connecteur électrique selon la revendication 1, **caractérisé en ce que** ladite bague (2) comprend un premier élément mis en forme (13) ayant essentiellement une forme de U, comprenant ladite paroi terminale (4) et ladite première paroi latérale (6) connectée par une première courbe à ladite paroi terminale (4), et un deuxième élément mis en forme (14) muni d'une partie en forme de U, qui comprend ladite paroi de fond (5) et une deuxième paroi latérale (15) connectée par une deuxième courbe à ladite paroi de fond (5) ; la première paroi latérale (6) dudit premier élément mis en forme (13) étant connectée mécaniquement par une relation de vissage à la deuxième paroi latérale (15) dudit deuxième élément mis en forme (14) ; lesdits éléments mis en forme (13, 14) délimitant entre eux la cavité interne (3) de ladite bague (2).

3. Connecteur électrique (1) selon la revendication 2, **caractérisé en ce que** lesdits moyens d'isolation électrique (45) comprennent un deuxième corps isolant (17), qui est muni d'une première ouverture (47) dirigée vers ladite paroi terminale (4) et traversée par lesdits éléments de contact électrique (7), et d'une deuxième ouverture (48) dirigée vers la paroi de fond (5) dudit deuxième élément mis en forme (14), faisant face à ladite paroi terminale (4) et traversée par ledit câble (9) desdits moyens de mesure ; ledit deuxième corps isolant (17) couvrant au moins partiellement la surface interne de la cavité interne (3) de ladite bague (2) et comprenant une partie annulaire destinée à couvrir la paroi de fond (5) dudit deuxième élément mis en forme (14) et une partie latérale destinée à couvrir la deuxième paroi latérale (15) dudit deuxième élément mis en forme (14).

4. Connecteur électrique (1) selon la revendication 3, **caractérisé en ce que** lesdits premiers moyens élastiques sont composés d'un ressort hélicoïdal (21) monté de manière coaxiale avec ledit câble (9) et s'appuyant, à une première extrémité, contre la partie annulaire dudit deuxième corps isolant (17) et, à une deuxième extrémité, contre la base commune (8) dudit élément de contact électrique (7).

5. Connecteur électrique (1) selon la revendication 4, **caractérisé en ce que** la deuxième extrémité du ressort hélicoïdal (21) s'engage dans une relation de rétention avec une projection (9) qui s'écarte de la base commune (8) en une direction opposée auxdites broches (10).

6. Connecteur électrique (1) selon la revendication 2, **caractérisé en ce que** le deuxième élément mis en forme (14) comprend une partie de col (22) qui s'écarte de ladite paroi de fond (5), et s'étend en une direction opposée à la deuxième paroi latérale (15) dudit deuxième élément mis en forme (14), ladite partie de col (22) étant fixée à un corps d'entretoise allongé (23) ; ledit connecteur électrique (1) comprenant également une gaine creuse (29) montée à l'extérieur de ladite entretoise (23) ; ladite entretoise (23) pouvant glisser dans ladite gaine (29) contre l'action des deuxièmes moyens élastiques (30).

7. Connecteur électrique (1) selon la revendication 6, **caractérisé en ce que** lesdits deuxièmes moyens élastiques (30) sont interposés entre un premier épaulement (27) de ladite entretoise (23) et un deuxième épaulement de ladite gaine creuse (29).
